# EUROPÄISCHE PATENTSCHRIFT

(11) **EP 2 754 183 B1**
(45) Veröffentlichungstag und Bekanntmachung des Hinweises auf die Patenterteilung: **28.06.2017**
(21) Anmeldenummer: 12751475.0
(22) Anmeldetag: 14.08.2012
(51) Int. Cl.: H01L 31/02

(54) **SOLARMODUL, PHOTOVOLTAIKANLAGE UND VERFAHREN ZUM BETRIEB EINER SOLCHEN**
SOLAR MODULE, PHOTOVOLTAIC SYSTEM AND METHOD FOR OPERATING SUCH A SYSTEM
MODULE SOLAIRE, INSTALLATION PHOTOVOLTAÏQUE ET PROCÉDÉ POUR FAIRE FONCTIONNER UNE TELLE INSTALLATION

(30) Priorität: 06.09.2011 DE 102011082162
(43) Veröffentlichungstag der Anmeldung: 16.07.2014
(73) Patentinhaber: SMA Solar Technology AG, 34266 Niestetal (DE)
(72) Erfinder: SCHIEMANN, Werner, 70734 Fellbach (DE)
(74) Vertreter: Lahnor, Peter
(86) Internationale Anmeldenummer: PCT/EP2012/065855
(87) Internationale Veröffentlichungsnummer: WO 2013/034403

(56) Entgegenhaltungen:
- DE-U1-202007 002 077
- FR-A3- 2 940 548

## Beschreibung

Die Erfindung betrifft ein Solarmodul mit einer Mehrzahl von mit einem Ausgangsanschluss verbundenen Solarzellen, als Bestandteil einer Photovoltaikanlage, die eine schaltbare Verbindung mit einer externen Last aufweist. Sie betrifft des Weiteren eine Photovoltaikanlage mit einer Mehrzahl derartiger Solarmodule sowie ein Verfahren zum Betrieb einer solchen.

### Stand der Technik

Anlagen zur photovoltaischen Energieerzeugung wurden in den letzten Jahren auf vielen Wohn- und Geschäftsgebäuden installiert. Üblicherweise wird in diesen eine größere Zahl von Solarmodulen auf dem Anlagendach aufgeständert, dabei wird meist eine größere Zahl von Bauteilen in einem oder mehreren Strängen zusammengefasst. Innerhalb des einzelnen Strangs sind die Module in Serie verschaltet, so dass der Strom durch den Strang zwar konstant ist, die Gesamtspannung jedoch proportional zur Zahl der verwendeten Solarmodule ansteigt. Typische Gesamtspannungen erreichen so Größenordnungen bis zu 1 kV Gleichspannung bei Strömen um 15 A. Die erzeugte Energie kann jedoch nicht direkt in das öffentliche Stromnetz eingespeist werden, sondern es muss zunächst eine Umwandlung von Gleich- in Wechselspannung stattfinden. Dazu wird ein sog. Wechselrichter benötigt, der insbesondere bei Wohnhäusern bevorzugt im Keller des Gebäudes installiert wird.

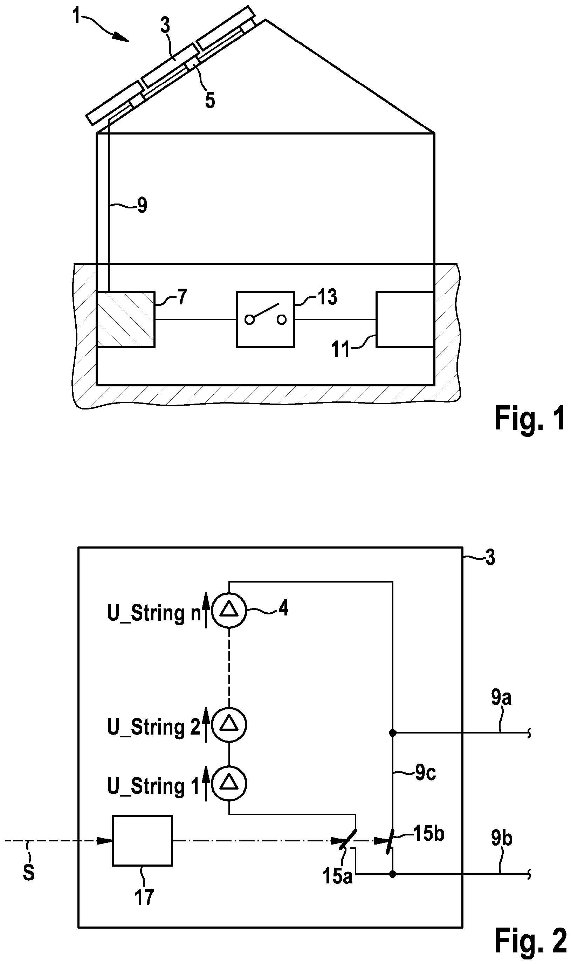

Wie in Fig. 1 schematisch dargestellt, verlaufen zwischen einer Photovoltaikanlage 1, die aus einer Mehrzahl von Solarmodulen 3 mit jeweils einer Anschlussdose 5 zusammengesetzt ist, auf dem Dach und einem Wechselrichter 7 im Keller Stromkabel 9, die ausreichende Anforderungen z. B. bezüglich Hochspannungssicherheit erfüllen müssen. Zwischen dem Wechselrichter 7 und einer externen Last 11 (etwa einer Netzeinspeisung oder einem hausinternen Energiespeicher) ist eine Schalteinrichtung 13 vorgesehen, mit der etwa eine Netztrennung der Photovoltaikanlage im Falle eines Brandes vorgenommen werden kann.

Im skizzierten System können unter gewissen Umständen Gefährdungspotentiale für Menschen, Tiere und Sachwerte bestehen. In den letzten Jahren wird in den Medien insbesondere eine Gefährdung durch hohe Spannungen im Brandfall diskutiert. Grundlage des Problems ist, dass die Solarmodule üblicherweise so lange eine Spannung produzieren, wie Licht auf sie einfällt. Wird im Brandfall ein Gebäude von der Feuerwehr von außen vom Stromnetz getrennt, ist zwar der Wechselspannungsausgang des Wechselrichters spannungsfrei, der Bereich zwischen Modulen und Wechselrichter führt allerdings immer noch die DC-Hochspannung. Wird das Kabel z. B. durch Brand oder mechanische Einwirkung beschädigt, liegt die Hochspannung an den Kabelenden frei an und kann zu elektrischen Schlägen führen, wenn die Feuerwehr das Gebäude während eines Löscheinsatzes betritt. Eine ähnliche Situation kann eintreten, wenn Wartungsarbeiten an Teilen der Anlage ausgeführt werden müssen.

Um dem Problem zu begegnen, wurden verschiedene Vorschläge gemacht mit dem Ziel, das Gebäudeinnere im Brandfall von gefährlicher Hochspannung freizuschalten. Zentrale Lösungen sind hierbei entweder, Einzelmodule oder Modulstränge kurzzuschließen oder Strang bzw. Modul von jeglichem Bezugspotential zu trennen, so dass bei Kontaktschluss auf Erde ebenfalls kein Stromfluss zustande kommt. Ein wesentliches Problem ist allerdings, dass aus Sicherheitsgründen bei Unsicherheit über den Zustand des Systems immer der spannungsfreie, ungefährliche Zustand angenommen werden muss. Nur wenn das System definitiv im betriebsbereiten Zustand ist, darf die Hochspannungsleitung unter Spannung stehen. Bisherige Ansätze fokussieren sich darauf, auf dem Hausdach entweder direkt an den Modulen (z. B. in der Anschlussdose) oder am Modulstrang einen Schalter vorzusehen, der die Freischaltung nur dann aufhebt, wenn z. B. vom Wechselrichter ein entsprechendes Signal kommt.

Als in diesem Zusammenhang einschlägige Druckschriften wird verwiesen auf DE 10 2005 018 173 B4, DE 10 2006 060 815 A1, DE 10 2008 004 675 B3, DE 10 2008 029 491 B4, DE 10 2008 003 272 A1, WO 2005/027300 A1,
WO 20107078303 A2 und US 2009/207 543 A1.

Dieser Ansatz ist zwar vergleichsweise sicher, verlangt allerdings eine permanente Kommunikation zwischen Wechselrichter (oder einer anderen Steuereinrichtung) und Schalter. Diese permanente Kommunikation kann
z. B. über ein eigenes Kabel, Wifi oder Powerline erfolgen, ist allerdings aufwendig zu realisieren und weist wegen des dauerhaften Betriebs sehr hohe Ansprüche an Robustheit der verbauten Komponenten auf.

Aus der DE 20 2007 002077 U1 ist eine Notschaltung für Solarstromanlagen mit einer Vielzahl von hintereinander geschalteten Solarstrom-Modulen bekannt, wobei eine angeordnete Schaltbox von einem Steuersignal angesteuert ist, welches Schaltkontakte in einer Schließstellung hält, und wobei eine Spannung auf der Gleichspannungsseite der Solarstrom-Module bei einer Netzspannungsunterbrechung abschaltet.

### Offenbarung der Erfindung

Mit der Erfindung wird ein eine Schutzschalteinrichtung einer Photovoltaikanlage umfassendes Solarmodul mit den Merkmalen des Anspruchs 1 bereitgestellt. Zweckmäßige Fortbildungen des Erfindungsgedankens sind Gegenstand der abhängigen Ansprüche. Weiterhin wird im Rahmen der Erfindung eine Photovoltaikanlage sowie ein Verfahren zum Betrieb einer solchen vorgeschlagen.

Ein wesentlicher Gedanke der Erfindung besteht im Vorsehen mindestens eines integrierten Schalters im Solarmodul, der dazu angeordnet und ausgebildet ist, den Ausgangsanschluss von einem spannungsfreien Ruhezustand in einen nicht spannungsfreien Betriebszustand bzw. von einem nicht spannungsfreien Betriebszustand in einen spannungsfreien Ruhezustand zu schalten. Weiterhin gehört es zur Erfindung, einen Fühler zur Erfassung einer den Verbindungszustand der Photovoltaikanlage mit der externen Last kennzeichnenden Größe im bzw. am Solarmodul vorzusehen. Weiterhin ist es wesentlich, dass das Solarmodul eine eingangsseitig mit dem Fühler verbundene Schaltersteuerung aufweist, welche zur periodischen Abtastung des Fühlerausgangs und zur Betätigung des Schalters oder der Schalter zur Umschaltung des Ausgangsanschlusses in den Betriebszustand im Ansprechen auf die Erfassung eines verbundenen Zustands der Photovoltaikanlage ausgebildet ist.

In einer zweckmäßigen und einfach zu realisierenden Ausführung ist der Fühler als Stromfühler zur Erfassung eines Stromflusses im Solarmodul im verbundenen Zustand der Photovoltaikanlage ausgebildet.

In einer weiteren Ausführung ist - zusätzlich zu dem eingangs erwähnten Fühler - ein mit einem Eingangsanschluss der Schaltersteuerung verbundener Spannungsfühler zur Erfassung einer vom Solarmodul bei Sonneneinstrahlung gelieferten Spannung vorgesehen.

In einer weiteren Ausführung ist die Schaltersteuerung und optional der Fühler über einen Versorgungsanschluss in das Solarmodul geschaltet, so dass die Stromversorgung autark im Solarmodul erfolgt. Des Weiteren kann - in Verbindung mit der letztgenannten Ausführung oder auch unabhängig von dieser - vorgesehen sein, dass der Schalter einen selbstleitenden Schalter, insbesondere MOSFET, zur spannungslosen Aufrechterhaltung des hochohmigen Ruhezustandes aufweist.

Eine weitere Ausgestaltung der vorgeschlagenen Lösung sieht vor, dass die Schaltersteuerung einen Zeitgeber zur Festlegung der, insbesondere einstellbaren, Zeitabstände der periodischen Abtastung des Fühlers aufweist. Durch geeignete Einstellung des Zeitgebers kann hierbei ein verträglicher Kompromiss zwischen den einander widerstreitenden Zielen, die durch den Abfühl- und Auswertungsvorgang bedingten Unterbrechungen des Energie liefernden Anlagenbetriebes zu minimieren, und die Abtastungen mit Blick auf die Betriebssicherheit möglichst häufig durchzuführen, erzielt werden.

In einer speziellen Ausführung ist das Solarmodul mit einem parallel zum Ausgangsanschluss angeordneten ersten und einem in Serie mit den Solarzellen geschalteten zweiten Schalter versehen, wobei die Schaltersteuerung zur Betätigung des ersten und zweiten Schalters gemäß einem vorbestimmten Schaltalgorithmus ausgebildet.

Erfindungsgemäß wird eine Photovoltaikanlage, die Solarmodule der oben beschriebenen Art aufweist, derart betrieben, dass jeweils innerhalb der Solarmodule periodisch abgefühlt wird, ob die Photovoltaikanlage in dem mit der Last verbundenen Zustand ist, und bei Feststellung eines verbundenen Zustandes der Ausgang jedes Solarmoduls nicht spannungsfrei geschaltet wird.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:
Fig. 1 eine skizzenartige Darstellung des Grundaufbaus einer Auf-Dach-Photovoltaikanlage,
Fig. 2 ein Prinzipschaltbild einer Ausführungsform des erfindungsgemäßen Solarmoduls und
Fig. 3 ein Blockschaltbild einer weiteren Ausführungsform des erfindungsgemäßen Solarmoduls.

### Ausführungsformen der Erfindung

Fig. 2 zeigt in einer stark reduzierten Darstellung als wesentliche Komponenten eines erfindungsgemäßen Solarmoduls 3 eine Mehrzahl von Solarzellenstrings 4 in einer Serienschaltung mit zwei Anschlussklemmen 9a, 9b, bei der ein erster Schalter 15a in Serie mit den Solarzellen-Strings 4 und ein zweiter Schalter 15b parallel zu diesen, in einer Überbrückungsleitung 9c zwischen den Klemmen 9a und 9b vorgesehen ist. Zur Steuerung der Schalter 15, 15b ist eine Schaltersteuerung 17 vorgesehen, welche eingangsseitig zum Empfang eines (hier nicht näher spezifizierten) Fühlersignals S ausgebildet ist.

Das Solarmodul verhält sich im nicht aktiven Zustand wie ein Kurzschluss und nicht, wie üblich, eine Stromquelle bzw. die Serienschaltung mehrerer Stromquellen. Erreicht werden kann dies durch den Schalter 15b parallel zu den Ausgangsklemmen des Moduls. Der ebenfalls gezeichnete Schalter 15a ist dabei nicht zwingend erforderlich. Alternativ dazu ist es möglich, auch Schalter 15b geöffnet zu lassen und Schalter 15a zu öffnen. Dadurch würde das Modul von außen hochohmig und ebenfalls spannungsfrei.

In einem zweiten Schritt prüft das Modul, inwiefern das Anlegen der bei Sonneneinstrahlung sich ergebenden Spannung an die externen Klemmen 9a, 9b einen Strom zur Folge hat, d. h. inwiefern ein externer Verbraucher angeschlossen ist. In diesem Fall wird das Modul seine normale Funktion aufnehmen, indem die Schaltersteuerung 17 den Schalter 15a schließt und den Schalter 15b öffnet. Die Versorgung der Steuerung erfolgt dabei über die Solarzellen des Moduls, siehe dazu weiter unten. Der gesamte Vorgang wiederholt sich zyklisch z. B. in Sekundenabständen. D. h. das Modul unterbricht regelmäßig seine reguläre Arbeit, um zu prüfen, inwiefern ein externer Verbraucher noch vorhanden ist. Ist dies nicht mehr der Fall, so geht das Modul sofort in den Sicherheitszustand.

Dadurch kann allein durch Unterbrechen der DC-Leitung die gesamte Photovoltaikanlage spannungslos geschalten werden. Die Wiederaufnahme der Funktion geschieht gleichermaßen durch einfaches Anschalten der Last.

Weitere Vorteile ergeben sich aus der Kombinierbarkeit dieser Funktion mit anderen Funktionen, z. B. zur Wirkungsgraderhöhung der Solarzellen. Mit einem entsprechenden System kombiniert, fällt die sich ergebende Verschlechterung des Wirkungsgrades (durch die Testzeit für angeschlossene Verbraucher) kaum noch ins Gewicht.

Technisch besteht die Möglichkeit, sowohl selbstleitende MOSFETS als selbstsperrende einzusetzen. Erstere bieten den Vorteil, auch völlig spannungslos - im Dunkeln - einen sicheren Kurzschluss darzustellen. Bei der zweiten Variante reichen geringe interne Spannungen aus, um die Sicherheitsfunktion darzustellen. Werden diese Spannungen unterschritten, ist ein Kurzschluss zwar nicht mehr gewährleistet, das Spannungsniveau zu Gefährdung von Personen jedoch ebenfalls zu gering.

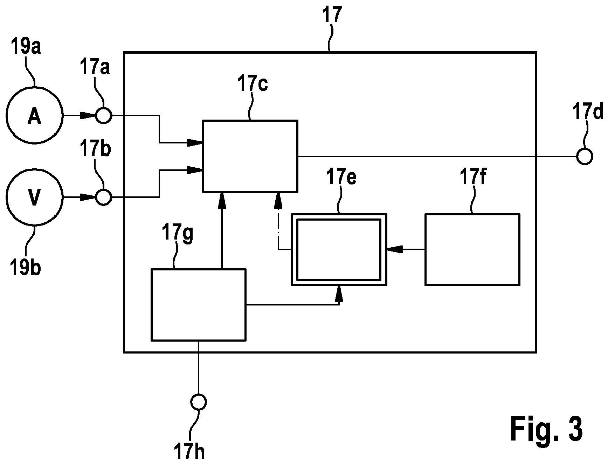

Fig. 3 zeigt den Aufbau einer Ausführung der Schaltersteuerung 17 eines erfindungsgemäßen Solarmoduls 3 in einer Prinzipskizze. Demnach hat die Schaltersteuerung 17 einen ersten Fühlersignal-Eingangsanschluss 17a, über den sie mit einem Stromfühler 19a zum Abfühlen eines Stromflusses in einem Solarzellen-String verbunden ist, und einen zweiten Fühlersignal-Eingangsanschluss 17b, über den sie mit einem Spannungsmesser 19b zur Erfassung einer durch Sonneneinstrahlung bewirkten Modulspannung verbunden ist. Der erste und zweite Fühlersignal-Eingangsanschluss 17a, 17b sind ihrerseits mit einer Fühlersignal-Auswertungsstufe 17c verbunden, die im Ergebnis der Abarbeitung eines vorbestimmten Fühlersignal-Auswertungsalgorithmus in vorbestimmten Zeitabständen an einem Steuersignal-Ausgangsanschluss 17d ein Schaltersteuersignal bereitstellt. Der Betrieb der Auswertungsstufe 17 wird durch einen Controller 17e gesteuert, der seinerseits von einem internen Timer 17f getriggert und ebenso wie die Auswertungsstufe 17e von einer Stromversorgungsstufe 17g versorgt wird, welche ihrerseits über einen Stromversorgungsanschluss 17h zur Eigenversorgung mit einem (nicht dargestellten) Abgreifpunkt des entsprechenden Solarmoduls verbunden ist.

Im Rahmen fachmännischen Handelns ergeben sich weitere Ausgestaltungen und Ausführungsformen des hier nur beispielhaft beschriebenen Verfahrens und der Vorrichtung.

## Patentansprüche

1. Solarmodul (3) mit einer Mehrzahl von mit einem Ausgangsanschluss (9a;9b) verbundenen Solarzellen (4), welches als Bestandteil einer Photovoltaikanlage (1) geeignet ist, die eine schaltbare Verbindung (13) mit einer externen Last (11) aufweist,
wobei das Solarmodul mindestens einen integrierten Schalter (15a;15b), der dazu angeordnet und ausgebildet ist, den Ausgangsanschluss von einem spannungsfreien Ruhezustand in einen nicht spannungsfreien Betriebszustand zu schalten, bzw. von einem nicht spannungsfreien Betriebszustand in einen spannungsfreien Ruhezustand zu schalten,
einen Fühler (19a) zur Erfassung einer den Verbindungszustand der Photovoltaikanlage mit der externen Last kennzeichnenden Größe und
eine eingangsseitig mit dem Fühler verbundene Schaltersteuerung (17) aufweist, welche zur periodischen Abtastung des Fühlerausgangs und zur Betätigung des Schalters oder der Schalter zur Umschaltung des Ausgangsanschlusses in den Betriebszustand im Ansprechen auf die Erfassung eines verbundenen Zustands, bzw. in den Ruhezustand im Ansprechen auf die Erfassung eines nicht verbundenen Zustands der Photovoltaikanlage ausgebildet ist.

2. Solarmodul nach Anspruch 1,
wobei der Fühler (19a) als Stromfühler zur Erfassung eines Stromflusses im Solarmodul (4) im verbundenen Zustand der Photovoltaikanlage (1) ausgebildet ist.

3. Solarmodul nach Anspruch 1 oder 2,
wobei zusätzlich ein mit einem Eingangsanschtuss der Schaltersteuerung (17) verbundener Spannungsfühler (19b) zur Erfassung einer vom Solarmodul bei Sonneneinstrahlung gelieferten Spannung vorgesehen ist.

4. Solarmodul nach einem der vorangehenden Ansprüche,
wobei die Schaltersteuerung (17) und optional der oder jeder Fühler (19a;19b) über einen Versorgungsanschluss (17h) in das Solarmodul (4) geschaltet ist, so dass die Stromversorgung autark im Solarmodul erfolgt.

5. Solarmodul nach einem der vorangehenden Ansprüche,
wobei der Schalter (15a;15b) einen selbstleitenden Schalter, insbesondere MOSFET, zur spannungslosen Aufrechterhaltung des spannungsfreien Ruhezustandes aufweist.

6. Solarmodul nach einem der vorangehenden Ansprüche,
wobei die Schaltersteuerung (17) einen Zeitgeber (17f) zur Festlegung der, insbesondere einstellbaren, Zeitabstände der periodischen Abtastung des Fühlers (19a) aufweist.

7. Solarmodul nach einem der vorangehenden Ansprüche, mit einem parallel zum Ausgangsanschluss angeordneten ersten (15b) und einem in Serie mit den Solarzellen geschalteten zweiten Schalter (15a),
wobei die Schaltersteuerung (17) zur Betätigung des ersten und zweiten Schalters gemäß einem vorbestimmten Schaltalgorithmus ausgebildet ist.

8. Photovoltaikanlage (1) mit einer Mehrzahl von Solarmodulen (4) nach einem der vorangehenden Ansprüche, einem Wechselrichter (7) und einer schaltbaren Verbindung (13) mit einer externen Last (11),
wobei die Verbindung insbesondere ausgangsseitig des Wechselrichters schaltbar ist.

9. Verfahren zum Betrieb einer Photovoltaikanlage (1) mit einer Mehrzahl von Solarmodulen (4) nach einem der vorangehenden Ansprüche, einem Wechselrichter (7) und einer schaltbaren Verbindung (13) mit einer externen Last (11),
wobei jeweils innerhalb der Solarmodule periodisch abgefühlt wird, ob die Photovoltaikanlage (1) in dem mit der Last (11) verbundenen Zustand ist, und bei Feststellung eines verbundenen Zustandes der Ausgang jedes Solarmoduls (4) nicht spannungsfrei geschaltet wird und bei Feststellung eines nicht verbundenen Zustandes der Ausgang jedes Solarmoduls (4) spannungsfrei geschaltet wird.

## Claims

1. A solar module (3) with a plurality of solar cells (4) connected to an output terminal (9a; 9b) and suitable as part of a photovoltaic system (1) comprising a switchable connection (13) to an external load (11), wherein the solar module comprises at least one integrated switch (15a; 15b) arranged and adapted to switch the output terminal between a high-resistance, zero potential idle state and a non-zero potential operating state, a sensor (19a) for detecting a parameter characterizing the connection status of the photovoltaic system to the external load, and a switch controller (17) connected to the sensor at an input side and configured to periodically sample the sensor output and to operate the switch or the switches for changing the output terminal into the operating state in response to the detection of a connected state of the photovoltaic system.

2. The solar module according to claim 1, wherein the sensor (19a) is formed as a current sensor for detecting a current flowing in the solar module (4) in the connected state of the photovoltaic system (1).

3. The solar module according to claim 1 or 2, wherein additionally a voltage sensor (19b) connected to an input terminal of the switch controller (17) is provided for detecting a voltage supplied by the solar module at insolation.

4. The solar module according to one of the preceding claims, wherein the switch controller (17) and optionally the sensor or each sensor (19a; 19b) is integrated into the solar module (4) via a supply connection (17h), such that the power supply is self-sustaining within the solar module.

5. The solar module according to one of the preceding claims, wherein the switch (15a; 15b) includes a normally-on switch, in particular a MOSFET, for sustaining the zero potential idle state without a supply.

6. The solar module according to one of the preceding claims, wherein said switch controller (17) comprises a timer (17f) for defining the, in particular adjustable, time intervals of the periodic sampling of the sensor (19a).

7. The solar module according to one of the preceding claims, with a first switch (15b) arranged in parallel to the output terminal and a second switch (15a) series-connected to the solar cells, wherein said switch controller (17) is configured to actuate the first and second switches according to a predetermined switching algorithm.

8. A photovoltaic plant (1) with a plurality of solar modules (4) according to any one of the preceding claims, an inverter (7) and a switchable connection (13) to an external load (11), wherein the connection is in particular switchable on the output side of the inverter.

9. A method of operating a photovoltaic system (1) with a plurality of solar modules (4) according to any one of the preceding claims, an inverter (7) and a switchable connection (13) to an external load (11), wherein it is periodically sampled within each of the solar modules, whether the photovoltaic system is in the connected state to the load, and upon detection of a connected state the output of each solar module is switched to the high resistance, zero potential state.

## Revendications

1. Module solaire (3) comprenant une pluralité de cellules solaires (4) reliées à une borne de sortie (9a ; 9b), lequel est conçu en tant qu'élément constitutif d'une installation photovoltaïque (1), laquelle possède une liaison commutable (13) avec une charge externe (11),
le module solaire possédant au moins un commutateur intégré (15a ; 15b) qui est disposé et conçu pour commuter la borne de sortie d'un état de repos à haute impédance ou hors tension en un état de fonctionnement à basse impédance ou non hors tension,
une sonde (19a) destinée à détecter une grandeur qui caractérise l'état de liaison de l'installation photovoltaïque avec la charge externe et
une commande de commutateur (17) dont l'entrée est reliée à la sonde, laquelle est conçue pour un palpage périodique de la sortie de la sonde et pour un actionnement du commutateur ou des commutateurs en vue de l'inversion de la borne de sortie dans l'état de fonctionnement en réaction à la détection d'un état connecté de l'installation photovoltaïque.

2. Module solaire selon la revendication 1, la sonde (19a) étant réalisée sous la forme d'une sonde de courant servant à la détection d'un flux de courant dans le module solaire (4) à l'état connecté de l'installation photovoltaïque (1).

3. Module solaire selon la revendication 1 ou 2, une sonde de tension (19b) reliée à une borne d'entrée de la commande de commutateur (17) étant en plus présente pour détecter une tension délivrée par le module solaire en présence du rayonnement solaire.

4. Module solaire selon l'une des revendications précédentes, la commande de commutateur (17) et, en option, la ou chaque sonde (19a ; 19b) sont connectées par le biais d'une borne d'alimentation (17h) dans le module solaire (4), de sorte que l'alimentation électrique s'effectue de manière autonome dans le module solaire.

5. Module solaire selon l'une des revendications précédentes, le commutateur (15a ; 15b) possédant un commutateur à conduction autonome, notamment un MOSFET, servant au maintien en l'absence de tension de l'état de repos hors tension.

6. Module solaire selon l'une des revendications précédentes, la commande de commutateur (17) possédant un temporisateur (17f) destiné à définir les intervalles de temps, notamment réglables, du palpage périodique de la sonde (19a).

7. Module solaire selon l'une des revendications précédentes, comprenant un premier commutateur (15b) monté en parallèle avec la borne de sortie et un deuxième commutateur (15a) branché en série avec les cellules solaires, la commande de commutateur (17) étant configurée pour actionner le premier et le deuxième commutateur conformément à un algorithme de commutation prédéfini.

8. Installation photovoltaïque (1) comprenant une pluralité de modules solaires (4) selon l'une des revendications précédentes, un onduleur (7) et une liaison commutable (13) avec une charge externe (11), la liaison étant commutable, notamment du côté de la sortie de l'onduleur.

9. Procédé pour faire fonctionner une installation photovoltaïque (1) comprenant une pluralité de modules solaires (4) selon l'une des revendications précédentes, un onduleur (7) et une liaison commutable (13) avec une charge externe (11), un sondage étant réalisé périodiquement à chaque fois à l'intérieur des modules solaires afin de déterminer si l'installation photovoltaïque se trouve dans l'état connecté à la charge, et si un état connecté est constaté, la sortie de chaque module solaire est commutée à haute impédance ou hors tension.
